Europäisches Patentamt

European Patent Office

Office européen des brevets

(19)

(11) Veröffentlichungsnummer: **0 212 208 B1**

# EUROPÄISCHE PATENTSCHRIFT

(45) Veröffentlichungstag der Patentschrift: **25.09.91**

(51) Int. Cl.⁵: **G01R 31/28**, G06F 11/26

(21) Anmeldenummer: **86109401.9**

(22) Anmeldetag: **09.07.86**

(54) Schaltungsanordnung zum Prüfen integrierter Schaltungseinheiten.

(30) Priorität: **24.07.85 DE 3526485**

(43) Veröffentlichungstag der Anmeldung:
**04.03.87 Patentblatt 87/10**

(45) Bekanntmachung des Hinweises auf die
Patenterteilung:
**25.09.91 Patentblatt 91/39**

(84) Benannte Vertragsstaaten:
**AT BE CH DE FR GB IT LI NL SE**

(56) Entgegenhaltungen:
**EP-A- 0 037 965**
**EP-A- 0 075 713**
**EP-A- 0 086 310**
**DE-A- 2 413 805**
**GB-A- 2 085 171**

(73) Patentinhaber: **Krug, Heinz**
**c/o Akademie MERU Station 24**
**NL-6063 NP Vlodrop(NL)**

(72) Erfinder: **Krug, Heinz**
**c/o Akademie MERU Station 24**
**NL-6063 NP Vlodrop(NL)**

(74) Vertreter: **Pellmann, Hans-Bernd, Dipl.-Ing. et
al**
**Patentanwaltsbüro Tiedtke-
Bühling-Kinne-Grupe-Pellmann-Grams-Struif**
**Bavariaring 4**
**W-8000 München 2(DE)**

## Beschreibung

Die Erfindung bezieht sich auf eine Schaltungsanordnung gemäß dem Oberbegriff des Patentanspruchs 1.

Eine Schaltungsanordnung dieser Art ist in der DE-A-31 30 714 als ein Testsystem beschrieben, das zum dynamischen Testen komplizierter Logikmodule zusammen mit diesen auf jedem zu testenden Halbleiterschaltungsplättchen hohen Integrationsgrads ausgebildet ist. Mit diesem Testsystem wird die Testzeit verkürzt und die Anzahl von für den Testvorgang erforderlichen Anschlüssen sowie von Testdaten verringert. Trotz der Verringerung der Testanschlüsse ist es aber erforderlich, vor einem Testvorgang im Testsystem Steuersignale und ggf. Eingangstestdaten zu speichern und nach dem Testzyklus die beim Test erhaltenen Ausgangssignale sofort oder nach einer Zwischenspeicherung einem externen Wartungsprozessor zuzuführen, der dann die Ausgangsdaten mit Solldaten vergleicht und damit eine "gut/schlecht"-Bewertung liefert. Ein solcher Wartungsprozessor ist jedoch zwangsläufig kostspielig, da er trotz einer in dem Testsystem eventuell vorgenommenen Datenkomprimierung eine sehr hohe Datenmenge schnell verarbeiten muß, um die Auswertungszeit kurz zu halten, und zusätzlich für die Bewertung unterschiedlicher Logikmodule umstellbar sein muß. Ferner ist der Wartungsprozessor bereits bei Anschluß eines einzigen Logikmoduls mit dem dazugehörigen Testsystem belegt, so daß keine parallele Testauswertung für mehrere Logikmodule möglich und folglich der Durchsatz an Logikmodulen herabgesetzt ist oder zur Steigerung des Durchsatzes mehrere der kostspieligen Wartungsprozessoren bereitgestellt werden müßten. Das Testsystem ist jeweils einem Logikmodul zugeordnet, so daß an diesem ein beträchtlicher Anteil der verfügbaren Halbleiterfläche für die Nutzung zur logischen Funktion verloren geht. Bei Zuordnung jeweils eines Testsystems zu den Logikmodulen wird zwar ein paralleles Testen der Module ermöglicht, nicht aber die Gesamtzeit für die Auswertung verkürzt, die nicht auf parallele Weise vorgenommen werden kann. Ferner ist nicht das Testen analoger Schaltungseinheiten vorgesehen.

In dem Artikel "In-Situ Testability Design" von Frank F. Tsui in Preceedings of the IEEE, Band 70, Nr. 1, Januar 1982, Seiten 59 bis 78 ist eine Schaltungsanordnung beschrieben, bei der an der Grundplatte (Wafer), an der eine Vielzahl integrierter Schaltungseinheiten (Chips) ausgebildet ist, viele mit einzelnen oder allen Schaltungseinheiten verbundene Außenanschlußflächen (Pads) vorgesehen sind. An diese Außenanschlüsse wird über eine entsprechende Schnittstelle ein Testgerät angeschlossen. Mit diesem Testgerät werden dann die Schaltungseinheiten an der Grundplatte geprüft. Hierbei wird jedoch vorausgesetzt, daß die Schaltungseinheiten digitale Einheiten sind, in denen zusätzlich zu den für den normalen Betrieb benötigten Bauelementen weitere Bauelemente mit Steueranschlüssen integriert sind, mit denen die Schaltungseinheit für die Prüfung in einen Pseudo-Betriebszustand geschaltet werden kann, bei dem die Funktionsfähigkeit aller Bauelemente ermittelt werden kann. Durch die zusätzlichen Bauelemente geht an den Schaltungseinheiten ein bestimmter Anteil der nutzbaren Fläche verloren, wobei ferner durch die erforderlichen zusätzlichen Anschlüsse die Anzahl von im tatsächlichen Betrieb nutzbaren Anschlüssen verringert wird. Durch das Anschließen der Grundplatte an die Schnittstelle der Testschaltung ist diese für die ganze Dauer des Prüfvorgangs belegt, so daß der Durchsatz an geprüften Grundplatten gering wird.

Der Erfindung liegt die Aufgabe zugrunde, die Schaltungsanordnung gemäß dem Oberbegriff des Patentanspruchs 1 derart auszugestalten, daß ein wirtschaftliches Prüfen ohne Einschränkung auf eine bestimmte Gestaltung der zu prüfenden integrierten Schaltungseinheiten ermöglicht ist.

Die Aufgabe wird erfindungsgemäß mit den im kennzeichnenden Teil des Patentanspruchs 1 genannten Mitteln gelöst.

Demnach ist erfindungsgemäß die Prüfschaltung derart ausgebildet, daß für mindestens einen Prüfparameter Istwerte mit Sollwerten verglichen werden, wozu die Prüfschaltung eine Zentraleinheit aufweist, mittels der das Prüfen einer Vielzahl von Schaltungseinheiten ausgeführt werden kann. Dabei wird eine Auswertung der Prüfergebnisse durch das Unterscheiden zwischen hinsichtlich mindestens eines Prüfparameters fehlerhaften und fehlerfreien Schaltungseinheiten und das Entscheiden der Funktionsfähigkeit der Schaltungseinheiten wie beispielsweise eine Klassifizierung hinsichtlich der Funktion vorgenommen. Somit wird erreicht, daß die einzelnen Schaltungseinheiten auf der Grundplatte einzeln für sich vollständig geprüft und bewertet werden, ohne daß die die Grundplatte an einen Wartungsprozessor angeschlossen werden muß. Infolgedessen müssen die Grundplatten bei der Prüfung lediglich an eine Spannungsquelle angeschlossen werden, wonach die Prüfschaltung mit ihrer Zentraleinheit selbsttätig die Prüfung und Bewertung der Schaltungseinheiten ausführt. Dabei kann eine Vielzahl von Grundplatten gleichzeitig und unabhängig voneinander geprüft werden, wobei lediglich eine entsprechende Spannungsversorgung bereitgestellt werden muß.

Die Prüfung kann je nach Erfordernis sehr ausführlich sein, da der Zeitaufwand hierfür keine Rolle spielt, weil dabei nicht die Rechnerzeit eines Wartungsprozessors in Anspruch genommen wird. Die Prüfschaltung mit der Zentraleinheit kann ferner ganz speziell entsprechend den zu prüfenden Schaltungseinheiten ausgebildet sein und auch die Testung analoger Schaltungen ermöglichen.

Da somit der Kostenaufwand für die Anschaffung eines Wartungsprozessors, insbesondere eines für verschiedenartige Schaltungseinheiten verwendbaren Wartungsprozessor und auch der Zeitaufwand für eine aufeinanderfolgende Prüfung von Grundplatten wegfallen, ermöglicht die erfindungsgemäße Schaltungsanordnung ein sehr wirtschaftliches Prüfen, weil die Einsparung an Kosten für die Prüfung die Mehrkosten für die erfindungsgemäße Ausgestaltung der Schaltungsanordnung übersteigt.

Vorteilhafte Ausgestaltungen der erfindungsgemäßen Schaltungsanordnung sind in den Unteransprüchen angeführt.

Die Erfindung wird nachstehend anhand von Ausführungsbeispiele unter Bezugnahme auf die Zeichnung näher erläutert.

Fig. 1 ist eine Draufsicht auf die erfindungsgemäße Schaltungsanordnung gemäß einem Ausführungsbeispiel.

Fig. 2 ist ein schematisches Schaltbild der Schaltungsanordnung.

Fig. 3 zeigt ein Beispiel für eine Schaltstufe der Schaltungsanordnung.

Fig. 4 zeigt ein Beispiel für die Stromversorgung einer zu prüfenden Schaltungseinheit.

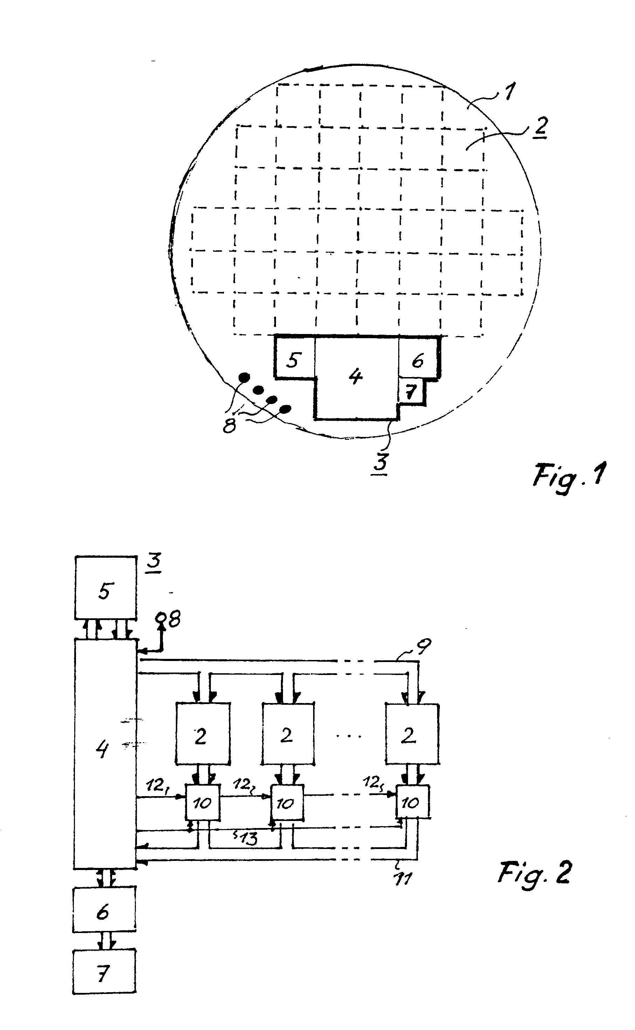

Die Fig. 1 ist eine schematische Draufsicht auf eine Grundplatte 1, auf der eine Vielzahl von zu prüfenden Schaltungseinheiten 2 in Form integrierter Schaltungen ausgebildet ist. Für die Prüfung ist an einem Teil der Grundplatte 1 eine durch starke Linien umrandet dargestellte Prüfschaltung 3 ausgebildet, die bei diesem Ausführungsbeispiel eine Zentraleinheit 4, einen Programmspeicher 5 und eine Ausgabeschaltung mit einem Ergebnisspeicher 6 und einer Anzeigevorrichtung 7 enthält. Ferner sind an der Grundplatte 1 Anschlußflächen 8 zum Außenanschluß ausgebildet.

Die Grundplatte 1 ist beispielsweise eine zur Halbleiterherstellung übliche Halbleiterscheibe (Wafer). Je nach Art der darauf auszubildenden Schaltungseinheiten kann die Grundplatte 1 auch irgendein anderes Substrat sein sowie auch andere Formen wie beispielsweise Rechteckform haben. Die zu prüfenden Schaltungseinheiten 2 können digitale, analoge oder gemischt digital/analoge Schaltungen sein. Je nach dem angestrebten Funktionsprinzip können die Schaltungseinheiten 2 ganz oder teilweise Supraleiter, organische bzw. biologische Schaltelemente, Lichtwellenleiter und dergleichen enthalten. Sie können für verschiedenartige Funktionen ausgelegt sein, also beispielsweise Bausteine vom einfachen Schaltglied oder Verstärker bis zu einem Speicher hoher Kapazität ergeben. Falls die Schaltungseinheiten 2 als Festspeicher dienen sollen, können sie zunächst als programmierbare Speicher gestaltet sein und im Zuge der Prüfung oder nach deren Abschluß auf die gewünschten Festwerte programmiert werden. Falls die Schaltungseinheit als Speicher mit Reservezellen ausgebildet ist, können diese im Bedarfsfall anstelle von bei der Prüfung als "schlecht" ermittelten Zellen eingeschaltet werden.

Die Prüfschaltung 3 nimmt zwar an der Grundplatte 1 eine größere Fläche als die einzelnen Schaltungseinheiten 2 ein, jedoch erspart sie in jede einzelne Schaltungseinheit eingebaute Testschaltungen, die insgesamt eine noch größere Fläche beanspruchen würden und die vor allem die Anzahl von Funktionselementen der Schaltungseinheiten herabsetzen würden. Die Prüfschaltung 3 enthält eine Art Mikroprozessor mit der Zentraleinheit 4 und dem Programmspeicher 5. Die Zentraleinheit 4 enthält Schnittstellen für die Verbindung mit den Schalteinheiten 2 und für die Steuerung dieser Verbindungen, Oszillatoren zum Erzeugen von Prüfsignalen, Taktsignalen, Steuersignalen und dergleichen, Zeitgeber zur Programmablaufsteuerung usw. Die Zentraleinheit 4 kann auch eine Eigentestschaltung enthalten sowie mit Reserveblöcken oder Reservekanälen versehen sein, welche bei dem Ausfall bestimmter Blöcke und Kanäle dem Eigentestergebnis entsprechend als Ersatz eingeschaltet werden können. Die Zentraleinheit 4 führt das in dem Programmspeicher 5 gespeicherte Prüfprogramm aus. Das Prüfprogramm wird je nach der Art der zu prüfenden Schaltungseinheiten, der Art der zu prüfenden Parameter, der erwünschten Genauigkeit und dergleichen gestaltet werden. Dementsprechend können für den Programmspeicher 5 jeweils passende Programmuster vorbereitet werden, die bei gleichbleibendem Schaltungsmuster der Zentraleinheit 4 wahlweise eingesetzt werden.

Ferner enthält die Prüfschaltung 3 die Ausgabeschaltung mit dem Ergebnisspeicher 6 und der Anzeigevorrichtung 7. Der Ergebnisspeicher 6 kann wie der Programmspeicher 5 in Abhängigkeit von den zu prüfenden Schaltungseinheiten und den Prüfkriterien gestaltet werden und wie der Programmspeicher wahlweise eingesetzt werden. In dem Ergebnisspeicher 6 können "gut-schlecht"-Daten, Fehlerartdaten, Gütebereichdaten und dergleichen gespeichert werden, die über die Zentraleinheit 4 als Prüfergebnisse eingegeben werden. Die Prüfdaten werden im Ergebnisspeicher 6 an vorbestimmten Speicherstellen gespeichert, die den jeweiligen Schaltungseinheiten 2 zugeordnet werden. Vorzugsweise wird der Ergebnisspeicher 6 als nichtflüchtiger Speicher wie beispielsweise als programmierbarer Festspeicher ausgebildet, dessen Speicherinhalt über die Zentraleinheit 4 abgerufen werden kann, um beispielsweise Prüfergebnisse auszudrucken oder den Prüfergebnissen entsprechende Reparaturen oder Markierungen vorzunehmen. Falls es möglich ist, an der Grundplatte 1 Reparaturen von fehlerhaften Schaltungseinheiten 2 auszuführen, wie z.B. mittels Laserstrahlen, wird der Ergebnisspeicher 6 als löschbarer programmierbarer Speicher (EPROM) gestaltet, der nach erfolgter Reparatur gelöscht und zum Speichern der Ergebnisse einer erneuten Prüfung herangezogen wird. Die Anzeigevorrichtung 7 dient dazu, die Prüfergebnisse in einem erwünschten Umfang sichtbar anzuzeigen. Die Anzeigevorrichtung 7 kann mit dem Inhalt des Ergebnisspeichers 6 angesteuert werden oder auch eigene Speicherzellen für bestimmte Prüfergebnisse wie z.B. hinsichtlich Güteklassen enthalten. Zweckdienlich weist die Anzeigevorrichtung 7 für eine jede zu prüfende Schaltungseinheit 2 mindestens ein Anzeigeelement auf, wie z.B. eine Leuchtdiode oder eine Schmelzverbindung, deren Schmelzzustand optisch erkennbar ist. Nach Fig. 1 sind die Anzeigeelemente der Anzeigevorrichtung 7 zu einem Anzeigefeld zusammengefaßt, in welchem die Anzeigeelemente im gleichen Muster wie die Schaltungseinheiten 2 angeordnet sind. Nach erfolgter Prüfung kann das Anzeigefeld auf automatische Weise und/oder durch Betrachtung mit einer Lupe oder einem Mikroskop ausgewertet werden, um eine Fehleranalyse auszuführen, fehlerhafte Schaltungseinheiten zusätzlich mit Farbe zu markieren, bei einer zu hohen Fehleranzahl die ganze Grundplatte auszumustern und dergleichen. Obgleich dies nicht dargestellt ist, können anstelle des Anzeigefelds oder zusätzlich zu diesem Anzeigeelemente jeweils in der Nähe der entsprechenden Schaltungseinheiten 2 angeordnet werden, was die Zuordnung bei der Auswertung der Prüfergebnisse erleichtert.

Die Anschlußflächen 8 an der Grundplatte 1 dienen zur Stromversorgung der Schaltungseinheiten 2 und der Prüfschaltung 3 sowie zur Eingabe und Ausgabe von Daten. Beispielsweise kann über eine jeweilige Anschlußfläche 8 der Speicherinhalt des Ergebnisspeichers 6 zu Registrierzwecken oder dergleichen ausgegeben werden oder es kann an die Zentraleinheit 4 ein Befehl zum Beginn der Prüfung, zum Ausführen einer bestimmten Teilprüfung oder im Falle bestimmter Prüfergebnisse zum Ausführen einer zusätzlichen Prüfung eingegeben werden.

Die Prüfschaltung 3 ist mit den Schaltungseinheiten 2 über Verbindungsleitungen und Schaltstufen auf die in Fig. 2 dargestellte Weise verbunden. Gemäß Fig. 2 führt eine Eingabe-Sammelleitung 9 zu den Eingängen aller Schaltungseinheiten 2, während die Ausgänge der Schaltungseinheiten über jeweils eine Schaltstufe 10 unter Steuerung durch die Prüfschaltung 3 mit einer gemeinsamen Ausgabe-Sammelleitung 11 verbunden werden, die zur Zentraleinheit 4 der Prüfschaltung 3 zurückführt. Die Schaltstufen 10 werden von der Zentraleinheit 4 über Steuerleitungen 12 und 13 gesteuert. Bei der Darstellung in Fig. 2 sind die Schaltstufen 10 zu einer Kettenschaltung in Form eines Schieberegisters geschaltet, in der sie über die zu einer Fortschaltleitung durchgeschleifte Steuerleitung 12 ·nacheinander ein- und ausgeschaltet werden. Die Steuerleitung 13 dient hierbei zur Übertragung von Taktsignalen für das Fortschalten.

Zur Prüfung einer einzelnen Schaltungseinheit 2 wird die entsprechende Schaltstufe 10 eingeschaltet, während alle übrigen Schaltstufen ausgeschaltet werden. Die Schaltungseinheit 2 erhält über die Eingabe-Sammelleitung 9 bestimmte Eingangssignale, die zu entsprechenden Ausgangssignalen auf der Ausgabe-Sammelleitung 11 führen sollten. In der Prüfschaltung 3 wird über die Zentraleinheit 4 festgestellt, ob die tatsächlich auf der Ausgabe-Sammelleitung 11 auftretenden Signalen den Sollsignalen entsprechen bzw. in Sollbereichen liegen.

Gleichartige Schaltstufen 10 können auch zwischen die Sammelleitung 9 und die Eingänge der Schaltungseinheiten 2 geschaltet werden und jeweils zusammen mit der betreffenden Schaltstufe 10 am Ausgang der Schaltungseinheit gesteuert werden. Dadurch kann eine übermäßige Belastung der zur Sammelleitung 9 führenden Ausgangsstufe der Zentraleinheit 4 durch die vielen Eingänge der Schalteinheiten 2 verhindert werden.

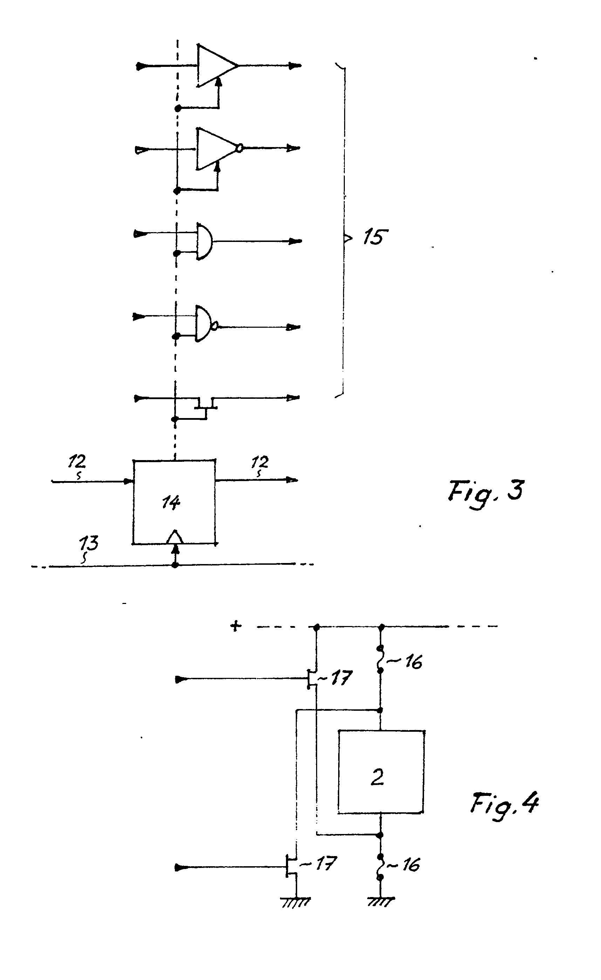

In der Fig. 3 ist schematisch der Aufbau einer Schaltstufe 10 gemäß einem Ausführungsbeispiel gezeigt. Demnach enthält die Schaltstufe 10 ein Speicherglied 14 und mindestens ein Schaltglied 15. Das Speicherglied 14 ist als Flipflop ausgebildet, welches bei der Gesamtschaltung nach Fig. 2 Bestandteil der Kettenschaltung ist und entsprechend dem Schaltzustand der vorangehenden Schaltstufe 10 über die Fortschaltleitung 12 unter Steuerung durch die Taktsignale auf der Steuerleitung 13 geschaltet wird. Ein Ausgangssignal des Speicherglieds 14 dient zum Schalten der jeweils angeschlossenen Schaltglieder 15, für die in der Fig. 3 schematisch einige Beispiele gezeigt sind. Gemäß Fig. 3 kann ein jeweiliges Schaltglied 15 ein geschalteter Puffer bzw. Verstärker, ein geschalteter Inverter, ein UND-Glied, ein NAND-Glied oder ein Schalttransistor sein. Die Schaltglieder werden entsprechend der Art Schaltungseinheiten 2 als analoge oder digitale Schaltglieder gestaltet. Ferner kann die Schaltstufe 10 mehrere Teilstufen gemäß Fig. 3 enthalten, die dann für aufeinanderfolgende Prüfschritte unterschiedliche Prüfbedingungen ergeben, wie Signalinversion, Pegeländerungen, Signalverknüpfungen oder dergleichen.

Die Fig. 4 veranschaulicht die Stromversorgung einer einzelnen Schaltungseinheit 2. Bei dem in der Fig. 4 gezeigten Beispiel ist in die beiden Stromversorgungs-Speiseleitungen der Schaltungseinheit 2 jeweils eine Schmelzbrücke 16 geschaltet, die bei einem übermäßigen Stromverbrauch durchschmilzt, wobei vorzugsweise ein solcher Schmelzzustand optisch erkennbar sein sollte. Damit dienen die Schmelzbrücken 16 als Sicherung zum Abtrennen einer fehlerhaften Schaltungseinheit 2, die die Stromversorgung aller Schaltungseinheiten verhindern und damit die Prüfung unmöglich machen würde. Ferner sind in der Fig. 4 zwei Schalttransistoren 17 gezeigt, mit denen unter Steuerung durch die Prüfschaltung 3 eine jeweilige Schmelzbrücke 16 absichtlich durch Anlegen der Speisespannung unterbrochen werden kann, um eine als fehlerhaft erkannte Schaltungseinheit zu markieren oder eine Beeinflussung der Prüfung durch eine solche, wie beispielsweise durch "wilde Schwingungen" zu verhindern. Derartige Schmelzbrücken 16 können auch in bestimmten Eingangs- und Ausgangsleitungen der Schaltungseinheiten 2 vorgesehen werden, damit durch eventuell auftretende Kurzschlüsse nicht die Zentraleinheit 4 außer Betrieb gesetzt wird. Ferner können anstelle der Schmelzbrücken 16 oder zusätzlich zu diesen weitere nicht gezeigte Schalttransistoren vorgesehen werden, mit denen unter der Steuerung durch die Prüfschaltung 3 jeweils nur eine der Schaltungseinheiten 2 oder eine Gruppe derselben mit Strom versorgt wird, um den Stromverbrauch während der Prüfung zu senken.

Die Schaltstufen 10, die Eingabe- und Ausgabe-Sammelleitungen 9 bzw. 11 sowie die Schmelzbrücken 16 und die Schalttransistoren 17 werden zusammen mit Speiseleitungen zur Stromversorgung zweckdienlich an Bereichen der Grundplatte 1 angeordnet, die bei der zum Zerteilen der Grundplatte 1 für das Erhalten der einzelnen Schaltungseinheiten 2 erforderlichen Bearbeitung durch Sägen, Laserstrahltrennung oder dergleichen wegfallen. Damit werden nach dem Zerteilen der Grundplatte 1 Schaltungseinheiten 2 erhalten, die geprüft sind und die lediglich die für ihre Funktion erforderlichen Bauelemente und Anschlüsse enthalten.

In der Figur 1 ist nur ein Beispiel für die Anordnung der Prüfschaltung 3 in Verbindung mit den Schaltungseinheiten 2 gezeigt. Alternativ kann die Prüfschaltung 3 statt an einer Seite der Grundplatte 1 gemäß Figur 1 auf den Umfang der Grundplatte 1 verteilt werden, für eine kürzere Leitungsführung in der Mitte der Grundplatte 1 angeordnet werden und bei der Bestückung der Grundplatte 1 mit unterschiedlichen Schaltungseinheiten 2 mit verschiedenen abrufbaren Programmspeichern versehen werden.

Die Schaltungsanordnung gemäß dem vorstehenden Ausführungsbeispiel ist mit elektrischen Leitern und Schalteinheiten für das Prüfen von Schaltungseinheiten für elektrische Signale beschrieben. Auf die gleiche Weise kann jedoch eine Schaltungsanordnung für das Prüfen von Schaltungseinheiten aufgebaut werden, bei denen zumindest zum Teil Lichtwellenleiter, Supraleiter, organische Leiter oder dergleichen eingesetzt werden. In diesem Fall sind die betreffenden Verbindungsleitungen und Schaltglieder der Schaltungsanordnung entsprechend auszugestalten.

Die Prüfschaltung 3 ist zwar nach Fig. 1 als auf einen außerhalb der Schaltungseinheiten 2 gelegenen Bereich liegend dargestellt, jedoch können auch Teile der Prüfschaltung wie beispielsweise Prüfsignalverstärker, digitaler Puffer, Grenzbereichsschalter u.dgl. nahe den Ausgängen oder Eingängen der Schaltungseinheiten angeordnet sein, um damit Fehlerfaktoren durch zu lange Prüfsignalleitungen auszuschließen.

## Patentansprüche

1. Schaltungsanordnung zum Prüfen von Schaltungseinheiten, die auf einer gemeinsamen Grundplatte zusammen mit einer Prüfschaltung und Schaltstufen als integrierte Schaltungen ausgebildet und über gemeinsame Speiseleitungen an der Grundplatte betreibbar sind, wobei die Schaltstufen durch die Prüfschaltung steuerbar sind und wobei die Prüfschaltung eine Ausgabeschaltung zur Ausgabe von Prüfdaten aufweist, dadurch gekennzeichnet, daß die Prüfschaltung (3) für den Vergleich von bei der Prüfung erhaltenen Istwerten mit Sollwerten für mindestens einen Prüfparameter ausgebildet ist und eine Zentraleinheit (4) aufweist, welche zum Prüfen einer Vielzahl von Schaltungseinheiten, zum Unterscheiden zwischen hinsichtlich mindestens eines Prüfparameters fehlerhaften und fehlerfreien Schaltungseinheiten und zum zeitlich aufeinanderfolgenden Entscheiden der jeweiligen Funktionsfähigkeit der Schaltungseinheiten ausgebildet ist.

2. Schaltungsanordnung nach Anspruch 1, dadurch gekennzeichnet, daß die Prüfschaltung (3) einen Programmspeicher (5) und in ihrer Zentraleinheit (4) einen Mikroprozessor aufweist.

3. Schaltungsanordnung nach Anspruch 1 oder 2, dadurch gekennzeichnet, daß die Prüfschaltung (3) zu einer Selbstprüfung ausgebildet ist und für Teile ihrer Funktion gleichwertige Schaltungsabschnitte enthält, die dem Selbstprüfungsergebnis entsprechend einschaltbar sind.

4. Schaltungsanordnung nach einem der vorangehenden Ansprüche, dadurch gekennzeichnet, daß die Stromversorgung der jeweiligen Schaltungseinheit (2) durch die Prüfschaltung (3) ein- und ausschaltbar ist.

5. Schaltungsanordnung nach einem der vorangehenden Ansprüche, dadurch gekennzeichnet, daß die jeweiligen Schaltungseinheiten (2) an die Speiseleitungen über Schmelzbrücken (16) angeschlossen sind, die bei internem Kurzschluß der zugeordneten Schaltungseinheit durchschmelzen oder mittels eines von der Prüfschaltung (3) angesteuerten Transistors (17) durch Anlegen der Speisespannung unterbrechbar sind.

6. Schaltungsanordnung nach einem der vorangehenden Ansprüche dadurch gekennzeichnet, daß die Ausgabeschaltung (6, 7) einen Ergebnisspeicher (6) mit den jeweiligen Schaltungseinheiten (2) zugeordneten Speicherstellen zur Speicherung einer Information über die Funktionsfähigkeit der jeweiligen Schaltungseinheit aufweist.

7. Schaltungsanordnung nach Anspruch 6, dadurch gekennzeichnet, daß der Ergebnisspeicher (6) als nichtflüchtiger Speicher ausgebildet ist.

8. Schaltungsanordnung nach Anspruch 6 oder 7, dadurch gekennzeichnet, daß die Speicherstellen des Ergebnisspeichers (6) über einen Außenanshluß (8) der Grundplatte (1) auslesbar sind.

9. Schaltungsanordnung nach einem der vorangehenden Ansprüche, dadurch gekennzeichnet, daß die Ausgabeschaltung (6, 7) eine Anzeigevorrichtung (7) zur Sichtanzeige der Prüfergebnisse aufweist.

10. Schaltungsanordnung nach Anspruch 9, dadurch gekennzeicnet, daß die Anzeigevorrichtung (7) mindestens ein Anzeigeelement für jede Schaltungseinheit (2) aufweist, wobei die Anzeigeelemente jeweils nahe der zugeordneten Schaltungseinheit (2) oder in einem separaten Anzeigefeld angeordnet sind.

11. Schaltungsanordnung nach Anspruch 10, dadurch gekennzeichnet, daß die Anzeigeelemente Leuchtdioden oder Schmelzverbindungen sind, deren Schmelzzustand optisch erkennbar ist.

12. Schaltungsanordnung nach Anspruch 11, dadurch gekennzeichnet, daß den Anzeigeelementen nichtflüchtige Speicherzellen zugeordnet sind.

13. Schaltungsanordnung nach einem der vorangehenden Ansprüche, dadurch gekennzeichnet, daß die Schaltstufen (10) und/oder Verbindungsleitungen (9, 11) zwischen den Schaltungseinheiten und der Prüfschaltung ·(3) an einem beim Zerteilen der Grundplatte (1) wegfallenden Plattenbereich ausgebildet sind.

14. Schaltungsanordnung nach einem der vorangehenden Ansprüche, dadurch gekennzeichnet, daß jede Schaltstufe (10) ein Speicherglied (14) und mindestens ein von demselben gesteuertes Schaltglied (15) für das Durchschalten einer Verbindungsleitung (9, 11) zu der betreffenden Schaltungseinheit (2) aufweist.

15. Schaltungsanordnung nach Anspruch 14, dadurch gekennzeichnet, daß die Speicherglieder (14) zu einer Kettenschaltung verbunden sind, in der ein Einschalt-Speicherzustand fortschaltbar ist.

16. Schaltungsanordnung nach einem der vorangehenden Ansprüche, dadurch gekennzeichnet, daß die Schaltstufen (10) zumindest zum Teil zum Schalten bzw. Leiten von elektrischen Signalen oder von Signalen in Form elektromagnetischer Strahlung ausgebildet sind.

17. Schaltungsanordnung nach einem der vorangehenden Ansprüche, dadurch gekennzeichnet, daß durch das Prüfergebnis der Prüfschaltung (3) als fehlerhaft ermittelte Schaltungseinheiten (2) durch Steuersignale aus der Prüfschaltung an mindestens einer der gemeinsamen Speiseleitungen und/oder Verbindungsleitungen (9, 11) vorübergehend oder dauerhaft abschaltbar sind.

**Claims**

1. Circuit arrangement for the testing of circuit units which are constructed on a common baseplate together with a test circuit and switching stages as integrated circuits and which can be operated via common power supply leads to the baseplate, such that the switching stages can be controlled by means of the test circuit and such that the test circuit has an output circuit for the outputting of test data, characterised in that the test circuit (3) is constructed for the comparison of actual values obtained during the testing with desired values for at least one test parameter, and has a central processing unit (4) which is constructed for the testing of a multiplicity of circuit units, for differentiating, on the basis of at least one test parameter, between defective and fault-free circuit units, and for deciding sequentially with time on the relevant serviceability of the circuit units.

2. Circuit arrangement according to Claim 1, characterised in that the test circuit (3) has a program memory (5) and a microprocessor in its central processing unit (4).

3. Circuit arrangement according to Claim 1 or 2, characterised in that the test circuit (3) is constructed for a self-test and contains circuit sections which are equivalent for the parts of their function, which circuit sections can be switched on in accordance with the result of the self-test.

4. Circuit arrangement according to one of the preceding claims, characterised in that the power supply to the respective circuit unit (2) can be switched on and off by means of the test circuit (3).

5. Circuit arrangement according to one of the preceding claims, characterised in that the respective circuit units (2) are connected to the power supply leads via fusible links (16) which melt through in the case of an internal short circuit of the associated circuit unit, or can be interrupted by application of the power supply voltage by means of a transistor (17) triggered by the test circuit (3).

6. Circuit arrangement according to one of the preceding claims, characterised in that the output circuit (6, 7) has a result memory (6) having the storage positions associated with the respective circuit unit (2) for storage of an item of information on the serviceability of the respective circuit unit.

7. Circuit arrangement according to Claim 6, characterised in that the result memory (6) is constructed as a non-volatile memory.

8. Circuit arrangement according to Claim 6 or 7, characterised in that the storage positions in the result memory (6) can be read out via an external connection (8) on the baseplate (1).

9. Circuit arrangement according to one of the preceding claims, characterised in that the output circuit (6, 7) has an indicator device (7) for visual indication of the test results.

10. Circuit arrangement according to Claim 9, characterised in that the indicator device (7) has at least one indicator element for each circuit unit (2), such that the indicator elements are arranged in each case close to the associated circuit unit (2) or in a separate indicator array.

11. Circuit arrangement according to Claim 10, characterised in that the indicator elements are light-emitting diodes or fusible connections, whose fused state can be recognised visually.

12. Circuit arrangement according to Claim 11, characterised in that non-volatile memory cells are associated with the indicator elements.

13. Circuit arrangement according to one of the preceding claims, characterised in that the switching stages (10) and/or connecting leads (9, 11) between the circuit units and the test circuit (3) are constructed on an area of the plate which is eliminated when the baseplate (1) is divided.

14. Circuit arrangement according to one of the preceding claims, characterised in that each switching stage (10) has a memory element (14) and at least one switching element (15), controlled by the same memory element, for the through-connection of a connecting lead (9, 11) to the circuit unit (2) concerned.

15. Circuit arrangement according to Claim 14, characterised in that the memory elements (14) are connected to a chain circuit in which a switch-on memory state can be incremented.

16. Circuit arrangement according to one of the preceding claims, characterised in that the switching stages (10) are constructed, at least in part, for the switching or conducting of electrical signals or of signals in the form of electromagnetic radiation.

17. Circuit arrangement according to one of the preceding claims, characterised in that circuit units (2) that are determined to be defective by means of the test result of the test circuit (3) can be temporarily or permanently switched off by means of control signals from the test circuit to at least one of the common power supply leads and/or connecting leads (9, 11).

**Revendications**

1. Montage de contrôle d'unités de circuit qui sont réalisées sous forme de circuits intégrés sur un substrat commun avec un circuit de contrôle et des étages de commutation et qui peuvent être mises en service par des conducteurs communs d'alimentation placés sur le substrat, les étages de commutation pouvant être commandés par le circuit de contrôle et le circuit de contrôle comprenant un circuit de sortie de données de contrôle, caractérisé en ce que le circuit de contrôle (3) est réalisé pour la comparaison de valeurs réelles obtenues par le contrôle avec des valeurs de consigne d'au moins un paramètre de contrôle et il comprend une unité centrale (4) qui est réalisée pour le contrôle de plusieurs unités de circuit, pour la différenciation d'unités de circuit qui sont défectueuses et sans défaut du point de vue d'au moins un paramètre de contrôle et pour prendre des décisions, qui se succèdent dans le temps, de l'aptitude au fonctionnement particulière des unités de circuit.

2. Montage selon la revendication 1, caractérisé en ce que le circuit de contrôle (3) comprend une mémoire de programme (5) ainsi qu'un microprocesseur placé dans son unité centrale (4).

3. Montage selon la revendication 1 ou 2, caractérisé en ce que le circuit de contrôle (3) est réalisé pour assurer son auto-contrôle et comprend des sections de circuit qui sont identiques pour des parties de sa fonction et qui peuvent être branchées en fonction du résultat de l'auto-contrôle.

4. Montage selon l'une des revendications précédentes, caractérisé en ce que l'alimentation en courant de chaque unité de circuit (2) peut être branchée et coupée par le circuit de contrôle (3).

5. Montage selon l'une des revendications précédentes, caractérisé en ce que chaque unité de circuit (2) est connectée aux conducteurs d'alimentation par des pontages fusibles (16) qui fondent en cas de court-circuit interne de l'unité correspondante de circuit ou qui peuvent être coupés par application de la tension d'alimentation au moyen d'un transistor (17) attaqué par le circuit de contrôle (3).

6. Montage selon l'une des revendications précédentes, caractérisé en ce que le circuit de sortie (6, 7) comprend une mémoire de résultat (6) qui comporte des cellules, dont chacune est affectée à une unité de circuit (2) et qui sont destinées à mémoriser une information concernant l'aptitude au fonctionnement de l'unité de circuit particulière.

7. Montage selon la revendication 6, caractérisé en ce que la mémoire de résultat (6) est réalisée sous la forme d'une mémoire non transitoire.

8. Montage selon l'une des revendications 6 et 7, caractérisé en ce que le contenu des cellules de la mémoire de résultat (6) peut être extrait par une connexion extérieure (8) du substrat (1).

9. Montage selon l'une des revendications précédentes, caractérisé en ce que le circuit de sortie (6, 7) comporte un dispositif (7) d'affichage visuel des résultats de contrôle.

10. Montage selon la revendication 9, caractérisé en ce que le dispositif d'affichage (7) comprend au moins un élément d'affichage pour chaque unité de circuit (2), chaque élément d'affichage étant disposé à proximité de l'unité de circuit (2) qui y est affectée ou dans une zone séparée d'affichage.

11. Montage selon la revendication 10, caractérisé en ce que les éléments d'affichage sont des diodes électroluminescentes ou des connexions fusibles dont l'état de fusion est décelable optiquement.

12. Montage selon la revendication 11, caractérisé en ce que des cellules non transitoires de mémoire sont affectées aux éléments d'affichage.

13. Montage selon l'une des revendications précédentes, caractérisé en ce que les étages de commutation (10) et/ou les conducteurs de connexion (9, 11) entre les unités de circuit et le circuit de contrôle (3) sont réalisés sur une zone du substrat qui est éliminée après fractionnement du substrat (1).

14. Montage selon l'une des revendications précédentes, caractérisé en ce que chaque étage de commutation (10) comprend un élément de mémoire (14) et au moins un organe de commutation (15) commandé par ce dernier et destiné à brancher un conducteur (9, 11) de connexion à l'unité de circuit (2) concernée.

15. Montage selon la revendication 14, caractérisé en ce que les éléments de mémoire (14) sont reliés en un circuit itératif dans lequel un état de branchement mémorisé peut faire l'objet d'une commutation progressive.

16. Montage selon l'une des revendications précédentes, caractérisé en ce que les étages de commutation (10) sont réalisés au moins en partie pour la transmission ou la conduction de signaux électriques ou de signaux ayant la forme d'un rayonnement électromagnétique.

17. Montage selon l'une des revendications précédentes, caractérisé en ce que les unités de circuit (2) détectées comme étant défectueuses par le résultat du contrôle effectué par le circuit correspondant (3) peuvent être découplées temporairement ou définitivement par des signaux de commande provenant du circuit de contrôle et envoyés à au moins l'un des conducteurs communs d'alimentation et/ou des conducteurs de connexion (9, 11).

Fig.1

Fig.2

10

Fig. 3

Fig. 4